# EUROPEAN PATENT SPECIFICATION

(11) **EP 0 532 971 B1**
(45) Date of publication and mention of the grant of the patent: **21.02.1996**
(21) Application number: 92114926.6
(22) Date of filing: 01.09.1992
(51) Int. Cl.: H01L 41/09

(54) **A progressive electrode for solid state motors**
Progressive Elektrode für Festkörper-Motor
Electrode progressive pour moteurs à matériaux d'état solides

(30) Priority: 18.09.1991 US 761561
(43) Date of publication of application: 24.03.1993
(73) Proprietor: CATERPILLAR INC., Peoria Illinois 61629-6490 (US)
(72) Inventor: Towe, Carey A., North Augusta, South Carolina 29841 (US); Greuel, Manfred (NMI), W-5000 Köln 50 (DE)
(74) Representative: Wagner, Karl H.

(56) References cited:
- US-A- 4 725 753

## Description

### 1. Field of the Invention

The field of the invention relates generally to solid state motor actuators. More particularly, the invention relates to a progressive electrode structure for applying voltage to piezoelectric solid state motor stacks to produce actuation.

### 2. Related Art

Piezoelectric solid state motor (SSM) stacks have been developed for many years for use in internal combustion engines. Such piezoelectric solid state motor stacks (simply referred to as "stacks") are primarily used for fuel injection actuation and valve control.

A common method for manufacturing stacks is by interleaving thin piezoelectric disks with metal foil electrodes. The piezoelectric ceramic (PZ) disks are then poled by application of a high voltage to two alternately interleaved groups of the foil electrodes. This poling process aligns the dipoles of the PZ disks to take full advantage of the electromechanical expansion characteristics of the disks. The stacks are enclosed in a protective housing before or after the poling process.

Once fully assembled, driving voltages on the order of 500-1000 VDC are applied to the stacks to produce axial expansion. The additive deflection of the stacked disks may be further amplified by hydraulics to provide useful actuation force. This actuation force must be on the order of a few kilo-newtons to open fuel injectors, and intake and exhaust valves, for instance.

An example of a conventional electromechanical actuator having active PZ elements is found in U. S. Patent No. 3,501,099 to Glendon M. Benson (the '099 patent). The '099 patent is directed to both an actuation amplification structure and a method for manufacturing PZ stacks.

The '099 patent shows forming ceramic sheets by a rolling process. The sheets are subsequently compacted and cut or punched to form the ceramic disks. After a cleaning process, the disks are stacked with alternate sets of continuous metal foil electrodes.

Two chain electrodes are used for each stack. Each continuous electrode comprises flat, circular electrodes with each circular electrode connected to a next circular electrode by a metal foil strap. The continuous electrodes may be stamped from foil or formed by photolithography.

The chain electrodes are then interleaved with the ceramic disks to form the stack. Lead wires are connected to the two ends of the chain electrodes. Thus, the circular electrodes of a particular chain electrode are electrically connected in series.

The '099 stacks then undergo a pressurized cool-welding process, followed by an elevated temperature and pressure bonding process. The stacks are poled by application of a DC voltage and then encapsulated with a plastic insulative cover prior to final mounting within a metal transducer housing.

The above described electrode structure represents a common serial approach to electrode interconnection. Another common interconnection scheme is the bus bar approach.

The bus bar scheme uses a common bar or wire to connect every other electrode in a parallel fashion. Each electrode includes a tab portion extending tangentially from a point on the circumference of the circular electrode. The tab is used to solder or weld the circular electrode to the bus bar. Conventionally, each stack uses two bus bars to connect the power supply leads to the two respective interconnected electrode groups in order to drive the PZ disks.

Both of the above discussed electrode interconnection structures suffer from various disadvantages. The '099 chain electrode structure complicates assembly of stacks. Furthermore, a break in one interconnecting strap in a chain electrode will prevent the application of voltage to the subsequent electrodes, causing inoperability of the remainder of the stack.

On the other hand, the bus bar structure can become somewhat rigid due to the soldering of the tabs, thus, inhibiting stack actuation. Moreover, assembly and soldering of the bus bar structure requires numerous process steps.

A modified bus bar structure is taught by U.S. Patent No. 4,641,052 to Kobayashi (the '052 patent). The '052 patent includes circular electrodes disposed between the PZ disks as in the stack structures discussed above. The '052 patent also includes slotted fiberglass bus bars, rather than solid metal bus bars.

Thin metal leads are patterned on the slotted fiberglass bus bars. The patterned metal leads electrically connect a driving voltage source to the circular electrodes of the stack. The circular electrode tabs are positioned in the slots and are soldered to the metal on the corresponding fiberglass bus bar.

Assembly of the '052 stacks requires manufacturing of the slotted fiberglass support, patterning of the metal on the fiberglass by deposition, for example, soldering of tabs to the bus bar and connection of the bus bars to lead wires for application of the driving voltage. These steps are complicated and expensive to automate, and would likely have low yield.

US-A-4 725 753 discloses an electrode structure in which a tab portion of each electrode extends radially out from the stack. Said tabs are contacted by electrically conductive studs.

Manufacturing stacks using the progressive electrode structure in conjunction with the present invention overcomes the deficiencies of the conventional technology noted above.

### SUMMARY OF THE INVENTION

The progressive electrode of the present invention is for use with piezoelectric solid state motor stacks having a plurality of piezoelectric disks, each disk having two opposing planar surfaces formed substantially parallel to one another.

The progressive electrode includes first and second pluralities of electrodes, each electrode having a thin, planar section for contacting a substantial portion of the planar surfaces of two adjacent disks such that the disks sandwich the planar section, and an elongated tab section formed integrally with the planar section, so as to extend outwardly from the motor. The first and second pluralities of electrodes are alternatively interleaved with the piezoelectric disks such that the motor expands in an axial direction when a driving voltage is applied to the first and second pluralities of electrodes.

The progressive electrode further includes first and second connectors for making electrical contact between the elongated tabs of each electrode of the first and second pluralities of electrodes, respectively, by physically bundling together the elongated tabs.

The planar section of each electrode may have a substantially circular geometry. In such an embodiment, the elongated tabs extend outward from a point at the periphery of the planar section to facilitate bundling of the tabs of the first and second pluralities of electrodes, respectively.

### BRIEF DESCRIPTION OF THE DRAWINGS

The invention will be better understood if reference is made to the accompanying drawings in which:
FIG. 1 shows a cross-sectional view of a housed, piezoelectric solid state motor stack with a progressive electrode in conjunction with the present invention;
FIG. 2 shows a circular electrode with an elongated tab in conjunction with the present invention; and
FIG. 3 shows a perspective view of a stack and the progressive electrode structure in conjunction with the present invention.

### DETAILED DESCRIPTION OF THE PREFERRED EMBODIMENTS

The present invention not only overcomes the deficiencies of conventional technology, as cited above, but also provides the following features and advantages.

The progressive electrode structure of the present invention requires no separate bus bar. As a result, no soldering or welding of electrode tabs to a bus bar is necessary. This permits simple and inexpensive automated manufacturing and assembly. In addition, the elimination of soldered or welded joints keeps the mass of each tab low, and permits free flexing of the tabs with stack actuation.

The gentle bundling of the elongated electrode tabs of the present invention permits the progressive electrode structure to better handle the stresses of piezoelectric stack expansion and contraction for longer periods of time, thus increasing the product life.

The bundling of the elongated electrode tabs of the present invention also simplifies the connection of the progressive electrode structure to lead wires and/or pins for application of the driving voltage.

The progressive electrode structure in conjunction with the present invention is designed for an automated manufacturing process to yield high-quality, high-durability solid state motor stacks in great volume.

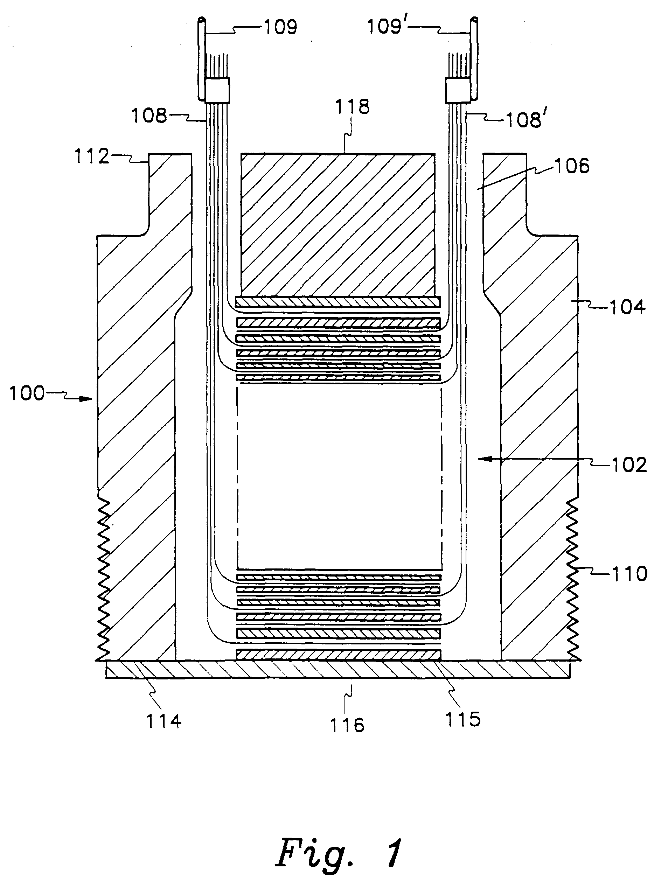

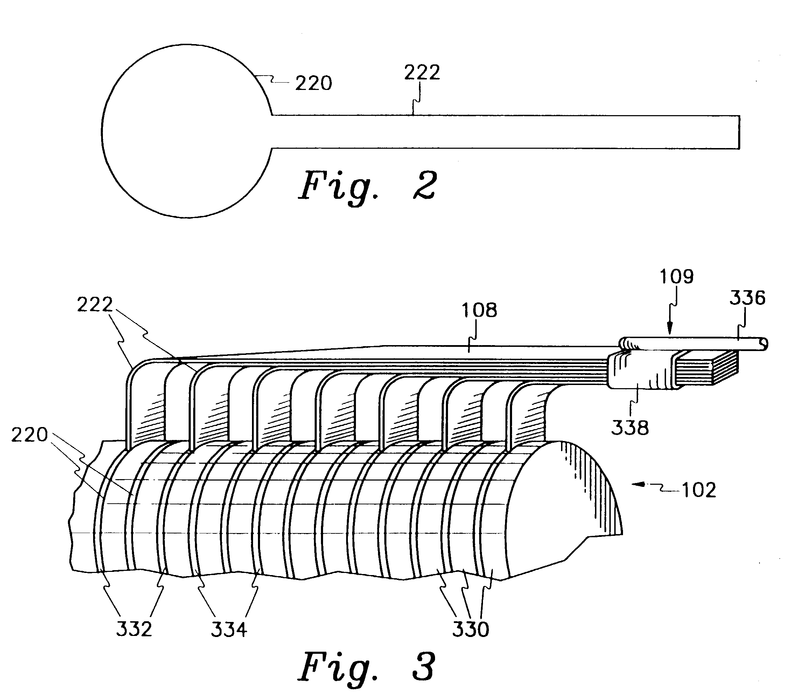

FIG. 1 shows a housed solid state motor stack 100, in conjunction with the present invention. An electrode/ceramic disk stack 102 is centered in a housing 104. The housing 104 may be formed of hardened steel and is cylindrical in shape with a hollow cylindrical cavity for housing the stack. Two throughports 106 are bored in the top end of the housing 104 to permit the progressive electrode structures 108 and 108' to exit the housing. Each of the electrodes of the progressive electrode structures 108,108' are bundled together by a connectors 109,109'. The progressive electrode structures 108,108' and electrical connectors 109,109' will be discussed in further detail below in conjunction with FIG. 3.

The housing 104 also includes a set of threads 110 which are used to attach the stack and housing to an engine head, for example. Housing 104 has a plateau region 112. As viewed from the top of FIG. 1, the plateau region 112 has a hexagonal cross section. This hexagonal shape is not shown in the figure, but it is used for tightening and loosening the piezoelectric solid state motor housing on the engine head.

An end surface 114 of the housing 104 and the exposed surface of a last ceramic disk 115 must be simultaneously ground to facilitate proper alignment of a diaphragm 116 to the end of the stack housing 104. The diaphragm 116 may then be laser-welded to the surface 114. This permits the end of the stack (i.e., the end surface of the disk 115) to be in contact with the diaphragm 116. Finally, a silicone encapsulant is injected to fill the cavities between the stack and the housing, as well as the gaps between adjacent electrode tabs of the progressive electrode structures 108,108'.

The diaphragm 116 is preferably made of stainless steel with thickness of about 0.1 mm. The steel diaphragm functions to protect the stack from external contaminates. In addition, the diaphragm prevents the electrode/disk stack from rotating within the housing, but since it is thin and flexible, it allows the stack to move axially with little restraint. The diaphragm and the housing have a preferred hardness of about 30 Rockwell C.

A piston is usually abutted against the diaphragm 116 when the stack is installed on an engine head. During installation, the stack is screwed onto the engine head and the diaphragm 116 transfers stresses to the housing. If no diaphragm were present, the friction between the end ceramic disk and the piston would cause the stack to rotate. Rotation of the stack would in turn cause disks to shear, and separate, and the silicone encapsulant would rupture. Such structural defects would detrimentally affect stack operation.

The section of the housing labeled 118 provides a fixed perch against which the stack is seated. Upon application of a driving voltage of about 1000V to the progressive electrode structures 108,108', the stack will expand in the axial direction against the fixed perch 118, thus causing the diaphragm 116 to move outward thereby producing actuation. Therefore, nearly all axial displacement occurs against the diaphragm 116; almost no axial displacement takes place at the end adjacent the section 118.

The basic structure of each electrode of the progressive electrode structures 108,108', will be discussed with reference to FIG. 2. Each individual electrode includes a circular section 220 and an elongated tab section 222. The electrodes are called "lollipop" electrodes, as evident by their general shape.

The lollipop electrodes are cut or stamped from metal foil using techniques well know in the art. The lollipop electrodes may be formed of copper alloys such as brass, or their known equivalents. The dimensions of the circular section 220 and the elongated tab section 222 are not critical to carrying out the present invention, but will become apparent to those working in the SSM art.

In a preferred embodiment of the present invention the foil has a thickness of about 0.05 mm. In a stack having 70 (or some even number of) ceramic disks, for example, each progressive electrode structure would have a thickness of about 1.75 mm, due to the additive thickness of each lollipop electrode (e.g., 35 lollipop electrodes per bundle).

A perspective view of a stack and the progressive electrode structure in connection with the present invention is shown in FIG. 3. The stack 102 includes a plurality of disks 330. The disks 330 are alternately interleaved with two sets of lollipop electrodes 332 and 334.

Each progressive electrode structure 108,108' comprises a set of lollipop electrodes which are bundled together by the electrical connectors 109,109'. One progressive electrode structure 108 includes a plurality of lollipop electrodes 332. A second progressive electrode structure 108' (see FIG. 1), would include a second plurality of lollipop electrodes 334. Electrode structures 108 and 108' are connected to the opposite sides of the high voltage source.

The electrical connector may take on a variety of shapes or configurations. The electrical connector 109 in FIG. 3 is shown as a crimp-type connector for both physically and electrically connecting together the elongated tabs 222. Wire wrapping may also be used to physically and electrically connect the elongated tabs 222 together.

A pin 336 is formed integrally with the electrical connector 109. The pin could be used to attach an external connector to the progressive electrode structure for application of a driving voltage. The pin 336 may comprise a solid piece of metal such as copper. The pin can be soldered to a clamp or crimp section 338 of connector 109, or be forged together therewith. Alternatively, the pin may be a multi strand wire, in which case it would be laser, resistance or ultrasonically welded to the crimp 338. The pin 336 may also be shaped to fit any conventional female jack, male plug or equivalent electrical connector.

While various embodiments of the present invention have been described above, it should be understood that they have been presented by way of example, and not limitation. Thus the scope of the present invention should not be limited by any of the above-described exemplary embodiments, but should be defined only in accordance with the following claims and their equivalents.

## Claims

1. A piezoelectric solid state motor having a housing (104), and a stack (102) in the housing (104) including a plurality of piezoelectric disks (330) having two opposing planar surfaces, and a plurality of electrode elements (108,108',332,334) each having a thin planar section (220), the electrode elements being configured to contact a substantial portion of the planar surfaces of two adjacent disks such that the adjacent disks sandwich the planar section (220) when assembled;
each electrode element including a single elongate tab section (222) formed integrally with the planar section (220) and extending alongside the stack (102) inside the housing (104);
the tab sections (222) of alternate electrode elements extending conterminous to a first position beyond the stack (102) and defining a first set of progressive electrodes (108,332);
the tab sections (222) of the other electrode elements being disposed in spaced relation to the first set of progressive electrodes (108) and extending conterminous to a second position beyond the stack (102) and defining a second set of progressive electrodes (108',334); and
means for separately interconnecting each of the first and second sets of progressive electrodes (108,108',332,334) and defining a common electrically conductive path for each set;
whereby the first and second sets of progressive electrodes (108,108',332,334) are adapted to be electrically connected to first and second electrical power supply potentials proximate the first and second positions beyond the stack (102), respectively.

2. The piezoelectric solid state motor according to claim 1, wherein said interconnecting means comprises a first and a second clamp (109,109') for separately interconnecting each of the first and second sets of progressive electrodes, respectively.

3. The piezoelectric solid state motor according to claim 1, wherein said interconnecting means comprises a first and a second wire wrap.

## Patentansprüche

1. Piezoelektrischer Festkörper-Motor, der ein Gehäuse (104) und einen Stapel (102) in dem Gehäuse (104) aufweist, welcher eine Vielzahl piezoelektrischer Scheiben (330) mit zwei entgegengesetzten, ebenen Oberflächen und eine Vielzahl von Elektrodenelementen (108, 108', 332, 334) mit je einem dünnen, ebenen Abschnitt (220) umfaßt, wobei die Elektrodenelemente so konfiguriert sind, daß sie einen wesentlichen Teil der ebenen Oberflächen von zwei benachbarten Scheiben kontaktieren, so daß die benachbarten Scheiben im zusammengebauten Zustand den ebenen Abschnitt sandwich-artig einfassen bzw. umgeben;
wobei jedes Elektrodenelement einen einzigen langgestreckten Laschen- oder Anschlußabschnitt (222) umfassen, der integral mit dem ebenen Abschnitt (220) ausgebildet ist und sich entlang des Stapels (102) innerhalb des Gehäuses (104) erstreckt;
wobei die Laschen- oder Anschlußabschnitte (222) abwechselnder Elektrodenelemente sich zusammen abschließend zu einer ersten Position jenseits des Stapels (102) erstrecken und einen ersten Satz progressiver bzw. gestaffelter Elektroden (108, 332) definieren;
wobei die Laschen- oder Vorsprungsabschnitte (222) der anderen Elektrodenelemente in beabstandeter Beziehung zu dem ersten Satz progressiver Elektroden (108) angeordnet sind und sich zusammen abschließend zu einer zweiten Position jenseits des Stapels (102) erstrecken und einen zweiten Satz progressiver bzw. gestaffelter Elektroden (108', 334) definieren; und wobei ferner Mittel vorgesehen sind zum gesonderten Verbinden von jedem der ersten und zweiten Sätze progressiver Elektroden (108, 108', 332, 334) miteinander und um einen gemeinsamen elektrisch leitenden Pfad für jeden Satz zu definieren;
wodurch die ersten und zweiten Sätze progressiver Elektroden (108, 108', 332, 334) in der Lage sind, mit ersten bzw. zweiten elektrischen Leistungsversorgungspotentialen in der Nähe der ersten bzw. zweiten Positionen jenseits des Stapels (102) elektrisch verbunden zu werden.

2. Piezoelektrischer Festkörper-Motor gemäß Anspruch 1, wobei die Verbindungsmittel eine erste und eine zweite Klemme (109, 109') aufweisen zum gesonderten Verbinden von jedem der ersten bzw. zweiten Sätze progressiver Elektroden miteinander.

3. Piezoelektrischer Festkörper-Motor gemäß Anspruch 1, wobei die Verbindungsmittel eine erste und eine zweite Drahtumwicklung aufweisen.

## Revendications

1. Moteur à matériau piézoélectrique comportant un boîtier (104) et un empilement (102) dans ce boîtier (104), comprenant une pluralité de disques piézoélectriques (330) ayant deux surfaces planes se faisant face, et une pluralité d'éléments d'électrodes (108, 108', 332, 334), chacun d'entre eux ayant une partie plane mince (220), les éléments d'électrodes étant configurés de façon à être en contact avec une partie notable des surfaces planes de deux disques adjacents, de telle sorte que les disques adjacents une fois montés prennent la partie plane (220) en sandwich ;
chaque élément d'électrode comprenant une seule partie de patte allongée (222) formée d'une seule pièce avec la partie plane (220) et s'étendant le long de l'empilement (102) dans le boîtier (104) ;
les parties de patte (222) d'éléments d'électrodes alternés s'étendant en s'approchant d'une première position au-delà de l'empilement (102) et définissant un premier jeu d'électrodes progressives (108, 332) ;
les parties de patte (222) des autres éléments d'électrodes étant disposées en relation espacée par rapport au premier jeu d'électrodes progressives (108) et s'étendant en s'approchant d'une seconde position au-delà de l'empilement (102) et définissant un second jeu d'électrodes progressives (108', 334) ; et
des moyens pour relier séparément chacun des premier et second jeux d'électrodes progressives (108, 108', 332, 334) et définir un chemin électriquement conducteur commun pour chaque jeu ;
caractérisé en ce que les premier et second jeux d'électrodes progressives (108, 108', 332, 334) sont adaptés à être électriquement connectés à des premier et second potentiels électriques d'alimentation proches des première et seconde positions au-delà de l'empilement (102), respectivement.

2. Moteur piézoélectrique selon la revendication 1, caractérisé en ce que les moyens de liaison comprennent un premier et un second collier de serrage (109, 109') pour relier séparément chacun des premier et second jeux d'électrodes progressives, respectivement.

3. Moteur piézoélectrique selon la revendication 1, caractérisé en ce que les moyens de liaison comprennent un premier et un second enroulement de fil conducteur.
